# EUROPEAN PATENT APPLICATION

(11) **EP 4 742 838 A1**
(43) Date of publication of application: **13.05.2026**
(21) Application number: 24212206.7
(22) Date of filing: 11.11.2024
(51) Int. Cl.: H05K 1/02, H05K 3/30

(54) **METHOD AND SYSTEM FOR ATTACHING A COMPONENT ON A SUBSTRATE**

(71) Applicant: Aptiv Technologies AG, 8200 Schaffhausen (CH)
(72) Inventor: HEBDA, Pawel, 8200 Schaffhausen (CH); ANTOS, Przemyslaw, 8200 Schaffhausen (CH)
(74) Representative: Bardehle Pagenberg Partnerschaft mbB Patentanwälte Rechtsanwälte

(57) **Abstract**

The present disclosure relates to a method (100) for attaching one or more components (3), such as a camera or a sensor, onto a substrate (10), such as a printed circuit board, PCB, the method comprising: arranging (110) a component (3) onto an attachment portion (11) of a substrate (10), wherein the attachment portion (11) is at least partially provided with an adhesive (12); curing (120) the adhesive (12) by at least partially heating the attachment portion (11) and thereby at least partially attaching the component (3) to the substrate (10); wherein at least partially heating the attachment portion (11) comprises directly heating the attachment portion (11).

## Description

### 1. Field of the invention

The present disclosure relates to a method and a system for attaching components such as cameras or sensors onto substrates, specifically printed circuit boards (PCBs). Specifically, the present disclosure relates to a method involving the use of adhesive and direct heating for curing the adhesive, as well as an active alignment process and a system for implementing the method.

### 2. Background

In the field of manufacturing electronic parts, it is common to attach various components, such as cameras or sensors, onto substrates like printed circuit boards (PCBs). In this field, active alignment processes are well known.

Active alignment processes allow the precise assembly of components, e.g., optical components, ensuring optimal performance in systems including but not limited to camera modules, projection devices, and augmented reality applications that maybe used in the automotive sector. While passive alignment methods rely on fixed positions, active alignment utilizes dynamic adjustments to align optical elements with high accuracy. This process may involve real-time feedback mechanisms, often incorporating imaging systems or laser measurements, to detect misalignments and correct them during assembly.

Known systems for attaching various components onto substrates like printed circuit boards (PCBs) involve the use of adhesives to secure these components onto the substrate. The adhesive is generally cured through a process of heating, which ensures that the component is firmly attached. Traditional methods often employ external heating mechanisms, such as infrared lamps for partially curing the adhesive, followed by a full cure in a oven, to achieve the necessary temperatures for curing the adhesive. These methods, while effective to some extent, present several challenges and notable drawbacks.

Firstly, the necessity of UV light for preliminary curing introduces complexity and additional equipment requirements into the assembly process. The UV light curing step necessitates specific clearance on the PCB to ensure adequate exposure, thereby limiting the available space for other components. Moreover, the reliance on UV light restricts the types of adhesives that can be used, as not all adhesives are compatible with UV curing.

Secondly, the requirement for an additional oven curing station further complicates the assembly line. This additional step not only increases the overall processing time but also demands more space and resources, thereby reducing the efficiency of the manufacturing process. The need for multiple curing stages-initial UV curing followed by oven curing-adds to the operational complexity and potential for defects.

It is therefore a technical problem underlying the present invention to provide an improved method and system that overcome the disadvantages of known systems.

### 3. Summary of the invention

The above-mentioned objects are at least partially achieved by the subject-matter of the independent claims. Preferred embodiments are subject of the dependent claims, and the skilled person finds hints for other suitable aspects of the present invention through the overall disclosure of the present application.

In particular, this object is addressed by a method for attaching one or more components, such as a camera or a sensor, onto a substrate, such as a printed circuit board, PCB, the method comprising: arranging a component onto an attachment portion of a substrate, wherein the attachment portion is at least partially provided with an adhesive; curing the adhesive by at least partially heating the attachment portion and thereby at least partially attaching the component to the substrate; wherein at least partially heating the attachment portion comprises directly heating the attachment portion.

In this manner, the invention offers several advantages over the prior art. By directly heating the attachment portion, the method is not dependent on provision of UV light lenses. Hence, the method may simplify the assembly process and may reduce the need for additional equipment. The direct heating mechanism may reduce processing time and allow for the use of a wider range of adhesive types. This may enhance manufacturing flexibility.

Furthermore, the method provides for an optimized space usage, as the UV light access clearance may no longer be required compared to known systems in the prior art.

Moreover, precision in attaching components due to the direct heating process may be improved. This may lead to stronger and more reliable bonds. This method may also enhance efficiency of the manufacturing process by reducing the time required for adhesive curing.

As can be gathered from further below, the method may also provide for multiple connection options for heater means, including connection pads on the surface, connection pads on the bottom layer, and additional connectors, thereby offering flexibility in design and integration without impairment of installation space. This may offer a streamlined, efficient, and versatile solution to the adhesive curing process in active alignment providing improvements in manufacturing efficiency and flexibility.

The term substrate may refer to the base material onto which components are attached, such as a PCB.

Component may refer to the items being attached, like cameras or sensors.

Attachment portion may refer to a specific area on the substrate where the component is placed.

Adhesive may be a substance used to bond the component to the substrate.

Curing may involve at least partially hardening the adhesive by applying heat.

Directly heating may refer to applying heat directly to the attachment portion, e.g., without intermediate steps.

In an embodiment of the method, directly heating the attachment portion comprises using heating means provided on the substrate.

By incorporating heating means directly on the substrate, the method ensures a more controlled and localized heating process, which can lead to more efficient and effective curing of the adhesive. This localized heating can reduce the risk of thermal damage to other parts of the substrate or the component itself, as the heat is applied precisely where needed. Additionally, this approach can enhance the overall reliability and durability of the attachment, as the adhesive is cured more uniformly and thoroughly.

The integration of heating means on the substrate also simplifies the overall process, potentially reducing the need for external heating equipment and thereby streamlining the manufacturing workflow. This can lead to cost savings and increased production efficiency.

Furthermore, the direct heating mechanism can be tailored to the specific requirements of different components and substrates, providing flexibility and adaptability in various applications.

In an embodiment of the method, the heating means comprises a heating element that is integrated in the substrate.

This integrated heating element provides a direct and efficient means of heating the attachment portion, thereby curing the adhesive and securing the component to the substrate.

By incorporating the heating element within the substrate, the method ensures a more controlled and localized heating process, which can enhance the precision and reliability of the attachment.

This feature eliminates the need for external heating sources, potentially reducing the complexity of the assembly process and improving the overall efficiency.

The integrated heating element can be designed to provide uniform heat distribution across the attachment portion, ensuring consistent curing of the adhesive and a robust attachment of the component.

Additionally, the integration of the heating element within the substrate can facilitate miniaturization of the assembly, as it reduces the need for additional space to accommodate external heating devices. This can be particularly advantageous in applications where space is limited, such as in compact electronic devices.

In an embodiment of the method, the heating element is distributed in a pattern in a top portion of the substrate.

The patterned distribution may optimize heat transfer to the adhesive, while the use of copper may enhance thermal conductivity, ensuring efficient and rapid heating.

In an embodiment of the method, directly heating the attachment portion comprises directly heating the adhesive.

This embodiment brings a more focused approach to the heating process, ensuring that the adhesive itself may be the target of the direct heating. This can enhance the efficiency and effectiveness of the curing process, potentially leading to a stronger and more reliable bond between the component and the substrate. By directly heating the adhesive, the method may achieve more precise control over the temperature and duration of the heating process, which can be helpful for sensitive components like cameras or sensors.

In an embodiment of the method, at least partially heating the attachment portion can be selectively activated by controlling auxiliary means, such as connection pins, wherein controlling auxiliary means is preferably performed in a space apart from the attachment portion.

This embodiment introduces the capability of selectively activating the heating process using auxiliary means, such as connection pins. Selective activation may provide precise control over the heating process, allowing for adjustments based on specific requirements and conditions, thereby enhancing the flexibility and efficiency of the method.

By using auxiliary means like connection pins, the method allows for targeted activation of the heating process, which can enhance the efficiency and accuracy of the attachment process.

Performed the control of the auxiliary means in a space apart from the attachment portion improves installation space. This may mean that connection pins are moved, e.g., up and down, in a space that is distant from the attachment portion.

In an embodiment of the method, controlling auxiliary means comprises contacting connection pads provided on the substrate with the auxiliary means to establish a connection of a heater circuit.

This establishes a connection of a heater circuit. The new feature introduced by this embodiment is the establishment of a connection between the auxiliary means and the substrate via connection pads. By ensuring that the connection pads on the substrate are in contact with the auxiliary means, a heater circuit is established, allowing for precise control over the heating process. In this manner the heating element of the heating means may be heated.

This ensures that the adhesive is cured effectively, securing the component to the substrate.

In an embodiment of the method, the connection pads are provided on the same side of the substrate where heating means is arranged, or the connection pads are provided on a side opposite to the side where heating means is arranged.

This embodiment introduces flexibility in the design and manufacturing process by allowing for different configurations of the connection pads relative to the heating means.

When the connection pads are on the same side as the heating means, it may facilitate a more straightforward heating process and potentially more efficient thermal transfer, leading to quicker and more uniform curing of the adhesive.

Conversely, when the connection pads are on the opposite side of the heating means, it might help in preventing any potential thermal damage to the connection pads or the components attached to them, thereby ensuring the integrity and functionality of the electrical connections.

In an embodiment, connection can be made by an additional connector, that may be provided on the same side of the substrate or the opposite side as described above. It may also be possible to provide a main camera connector, e.g., when the component is a camera.

In an embodiment of the method, the attachment portion comprises an attachment path that preferably resembles one or more contact surfaces of the component.

The inclusion of an attachment path that resembles the contact surfaces of the component enhances the precision and reliability of the attachment process. By ensuring that the attachment path aligns closely with the contact surfaces, the method allows for a more secure and accurate placement of the component onto the substrate. This alignment minimizes the risk of misalignment or improper adhesion, which can lead to functional issues or failure of the component.

Additionally, the resemblance of the attachment path to the contact surfaces can facilitate a more efficient curing process of the adhesive, as the heat can be more evenly distributed across the surfaces that are in contact. This can result in a stronger bond between the component and the substrate, improving the overall durability and performance of the attached component.

In an embodiment of the method, directly heating the attachment portion comprises using radiation convection, and/or conduction as heat transfer mechanisms.

Radiation involves the transfer of heat through electromagnetic waves, which can be achieved using infrared lamps or laser beams to target the adhesive area precisely. Convection involves the transfer of heat through the movement of fluids or gases, which can be implemented by directing hot air or gas flow towards the adhesive area to facilitate the curing process. Conduction involves the transfer of heat through direct contact between materials, which can be achieved by placing a heated element in direct contact with the attachment portion to ensure efficient heat transfer.

The introduction of these specific heat transfer mechanisms provides flexibility in the choice of heating techniques, allowing for optimization based on the specific requirements of the component and substrate materials. This flexibility can lead to improved control over the heating process, ensuring that the adhesive is cured uniformly and effectively without causing damage to the component or substrate. Additionally, the use of different heat transfer mechanisms can enhance the efficiency and speed of the curing process, potentially reducing the overall time required for attachment.

By specifying these mechanisms, the method can be tailored to various industrial applications, accommodating different types of components and substrates, and addressing specific challenges related to heat sensitivity and adhesive properties.

In an embodiment of the method, the adhesive comprises thermoset polymers, preferably, the adhesive consists of thermoset polymers.

This feature brings several advantages to the method. Thermoset polymers, once cured, form a strong, durable bond that is resistant to heat and chemical degradation. This enhances the reliability and longevity of the attachment, ensuring that the components remain securely attached to the substrate under various operating conditions. Additionally, thermoset polymers typically have excellent mechanical properties, such as high tensile strength and modulus, which contribute to the structural integrity of the attachment.

In the prior art, the reliance on UV light restricts the types of adhesives that can be used, as not all adhesives are compatible with UV curing.

In an embodiment of the method, the method is further comprising further curing the cured adhesive using an oven for attaching the component onto the substrate.

This additional step of using an oven for further curing enhances the attachment of the component onto the substrate. The further curing process ensures that the adhesive is fully cured, which can improve the strength and durability of the attachment.

In an embodiment of the method, one or more contact surfaces of the component form a frame.

The frame structure of the contact surfaces can provide a more stable and secure attachment of the component to the substrate, as the frame can distribute the adhesive more evenly and ensure better contact between the component and the substrate. Moreover, the rectangular shape of the frame can facilitate easier alignment and positioning of the component during the attachment process, reducing the risk of misalignment and improving the overall precision of the attachment.

As understood, difference shapes of the one or more contact surfaces of the component may be encompassed.

In an embodiment of the method, at least partially heating the attachment portion does not comprise using means for employing UV light. As understood, natural UV light may not be excluded but rather specific equipment for providing said UV light.

The objects are also achieved by an active alignment process for one or more components, such as a camera or a sensor, the process comprising: performing the method according to any one of the preceding embodiments for attaching a component onto a substrate, such as a printed circuit board, PCB, wherein curing the adhesive is performed until a predefined temperature of the adhesive is reached.

Curing the adhesive used for attachment until it reaches a predefined temperature may ensure that the adhesive has properly set, providing a secure and precise alignment of the component on the substrate.

The advantage of this method is that it allows for precise positioning and stability of the components, which is crucial for the optimal performance of components such as cameras and sensors without the use of UV light and without a separate step in an oven.

The objects are also achieved by a system for carrying out the method or the process, the system comprising: a substrate, such as a printed circuit board, PCB, the substrate comprising an attachment portion for arranging a component on it; heating means provided on the substrate; wherein the heating means is configured to cure an adhesive comprised by the attachment portion by at least partially heating the attachment portion and thereby at least partially attaching a component to the substrate; wherein at least partially heating the attachment portion comprises directly heating the attachment portion.

The advantages of this system include precise and efficient attachment of components to the substrate, improved reliability of the adhesive bond due to controlled heating, and potential reductions in manufacturing time and costs by integrating the heating means directly into the substrate. This direct heating approach ensures that the adhesive is cured effectively, enhancing the overall quality and durability of the assembled product.

Moreover, it is noted that the features, aspects, embodiments and/or advantages as described herein with reference to the method are likewise applicable to the system and *vice versa.*

### 4. Brief description of preferred embodiments

In the following, preferred embodiments of the disclosure are disclosed by reference to the accompanying figures.
- Fig. 1:: illustrates a system and exemplary method steps according to an embodiment of the invention.
- Fig. 2:: illustrates Fig. 1 during an exemplary method step.
- Fig. 3:: illustrates Fig. 1 in another exemplary arrangement.
- Fig. 4:: illustrates Fig. 1 in yet another exemplary arrangement.
- Fig. 5:: illustrates a flow chart of a method.

### 5. Detailed description of the figures

In the subsequent passages, the invention is described with reference to the accompanying figures in more detail. It is noted that further embodiments are certainly possible, and the below explanations are provided by way of example only, without limitation. Throughout the present figures and specification, the same reference numerals refer to the same elements. The figures may not be to scale, and the relative size, proportions, and depiction of elements in the figures may be exaggerated for clarity, illustration, and convenience.

While specific feature combinations are described in the following with respect to exemplary embodiments of the present disclosure, it is to be understood that not all features of the described aspects have to be present for realizing the technical advantages provided by the present disclosure, which is defined by the subject matter of the claims.

The disclosed aspects may be modified by combining certain features of one aspect with one or more features of another aspect. Specifically, the skilled person will understand that features, components and/or functional elements of one aspect can be combined with technically compatible features, components and/or functional elements of any other aspect of the present disclosure given that the resulting combination falls within the definition of the present disclosure. The skilled person also understands that certain features may be omitted in so far as they appear dispensable.

It is noted that when features, aspects, and/or embodiments are described herein by the term "substantially", manufacturing tolerances must be taken into consideration. In this manner, minor deviations during any kind of manufacturing, assembling or the like may pertain. Further, manufacturing tolerances, aging effects, or other minor defects or the like may pertain. These are all encompassed by the term "substantially". Although not always explicitly expressed by using the term "substantially", it is understood that the elements, parts, units, shapes, and / or the like described herein may nevertheless comprise such manufacturing tolerances.

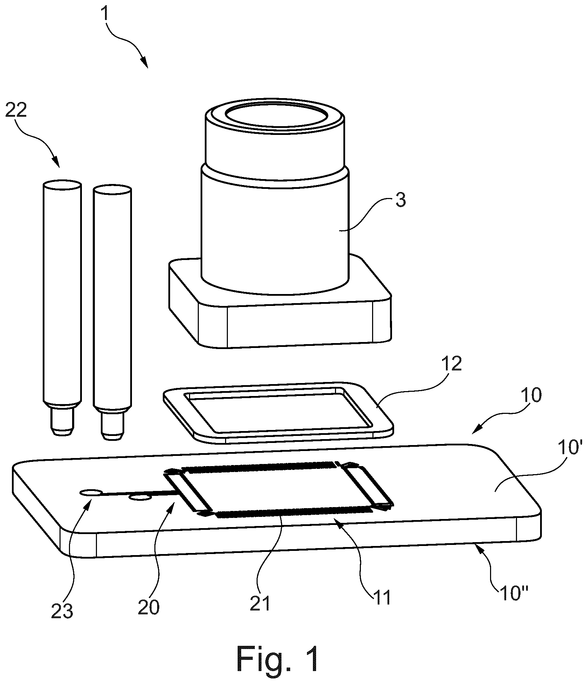

**Fig. 1** illustrates a system 1 for curing adhesive 12 in, e.g., an active alignment process. The system 1 comprises a substrate 10 with an attachment portion 11 where a component 3 is to be arranged. The attachment portion 11 includes adhesive 12 for securing the component 3 to the substrate 10. Heating means 20 are integrated into the substrate 10 and may be positioned in the adhesive path distribution area. The heating means 20 include a heating element 21 that directly heats the adhesive 12 through radiation, convection, and/or conduction. Auxiliary means 22, such as connection pins, 22 are provided to control the activation of the heating element 21. Connection pads 23 are located on the substrate 10 to establish a heater circuit when contacted by the auxiliary means 22 so as to heat the heating element 21 of the heating means 22. The heating element 21 can be distributed in a specific pattern in the top portion of the substrate 10.

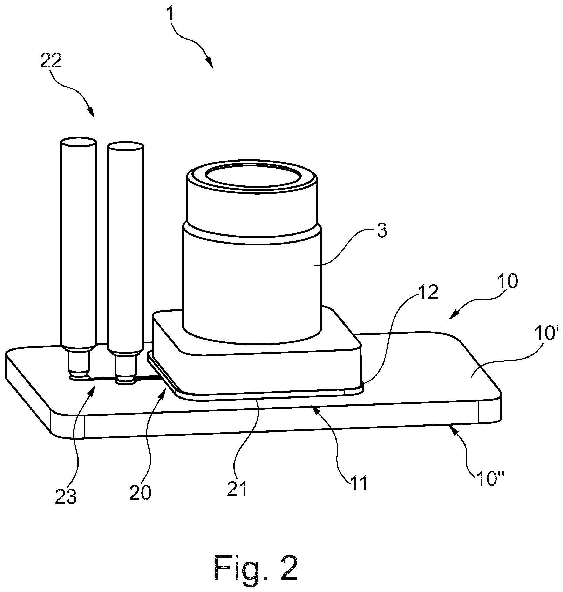

**Fig. 2** depicts the same system 1 as in Figure 1, with a focus on the arrangement of the component 3 onto the attachment portion 11 of the substrate 10. Unlike Fig. 1, Fig. 2 is shown at a different method step, as the component 3 is already arranged on the substrate 10. The method 100 involves arranging 110 the component 3 onto the attachment portion 11, which comprises adhesive 12. The heating means 20, including the heating element 21, are shown integrated into the substrate 10. The connection pads 23 are visible on the same side 10' of the substrate where the heating means 20, specifically the heating element 21 is arranged. The auxiliary means 22 are configured to contact the connection pads 23 to activate the heating element 21 and initiate the curing 120 step.

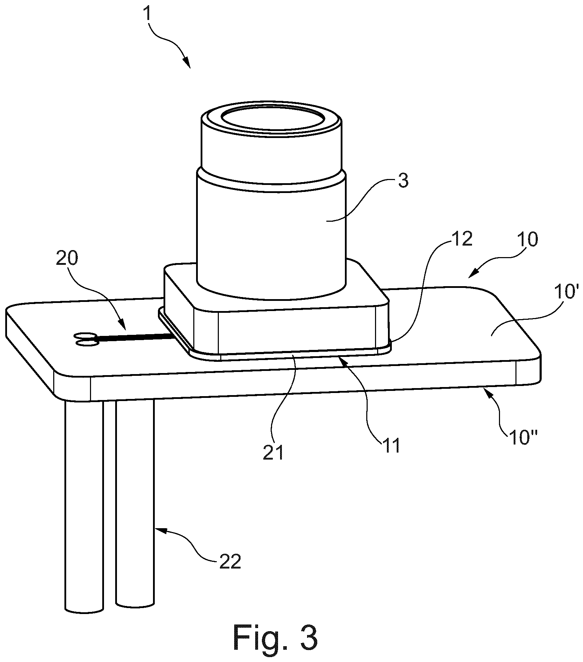

**Fig. 3** illustrates another configuration of the system 1, where the connection pads 23 are located on the opposite side 10" of the substrate 10' from the heating means 20, specifically the heating element 21. The component 3 is arranged on the attachment portion 11 with adhesive 12. The heating means 20 are integrated into the substrate 10 and positioned in the adhesive path distribution area. The auxiliary means 22 are shown contacting the connection pads 23 on the opposite side 10" of the substrate to establish a heater circuit and activate the heating element 21 for curing 120 the adhesive 12.

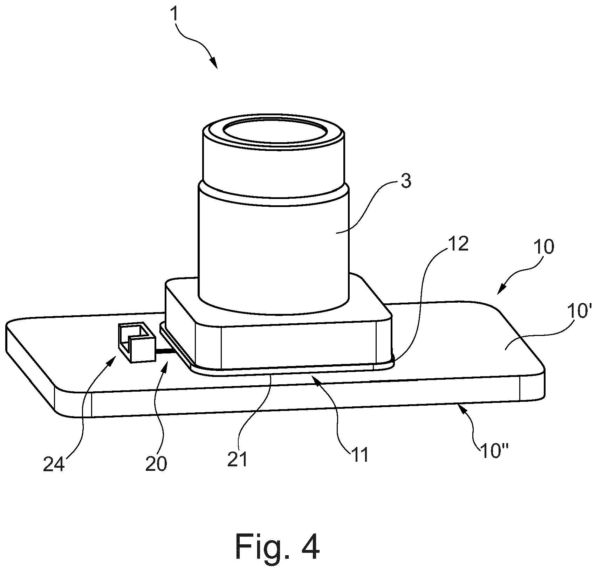

**Fig. 4** presents another variation of the system 1, where instead of connection pads an additional connector 24 is provided. The component 3 is arranged on the attachment portion 11 with adhesive 12. The heating means 20 are integrated into the substrate 10 and positioned in the adhesive path distribution area. The additional connector 24 is shown to be on the same side 10' of the substrate 10 as the heating element 21, however, this may also be on the opposite side 10".

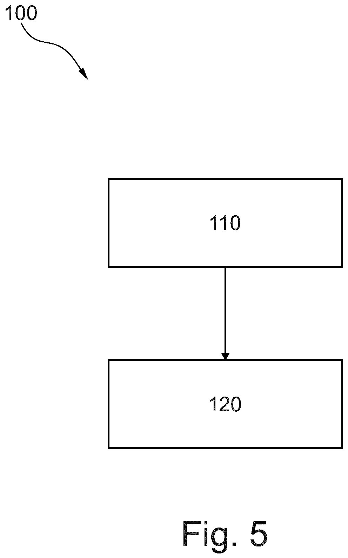

**Fig. 5** illustrates a flow chart of a method 100 for attaching one or more components, such as a camera or a sensor, onto a substrate, such as a printed circuit board, PCB, the method comprising:
arranging 110 a component onto an attachment portion of a substrate, wherein the attachment portion is at least partially provided with an adhesive;
curing 120 the adhesive by at least partially heating the attachment portion and thereby at least partially attaching the component to the substrate;
wherein at least partially heating the attachment portion comprises directly heating the attachment portion.

It is to be noted that the scope of protection is determined by the claims and is not limited by the embodiments disclosed in the above figures.

### 6. List of reference signs

- 1: system
- 3: component
- 10: substrate
- 10': same side of substrate
- 10": opposite side of substrate
- 11: attachment portion
- 12: adhesive
- 20: heating means
- 21: heating element
- 22: auxiliary means
- 23: connection pads
- 24: additional connector

- 100: method
- 110: arranging
- 120: curing

## Claims

1. A method (100) for attaching one or more components (3), such as a camera or a sensor, onto a substrate (10), such as a printed circuit board, PCB, the method comprising:
arranging (110) a component (3) onto an attachment portion (11) of a substrate (10), wherein the attachment portion (11) is at least partially provided with an adhesive (12);
curing (120) the adhesive (12) by at least partially heating the attachment portion (11) and thereby at least partially attaching the component (3) to the substrate (10);
wherein at least partially heating the attachment portion (11) comprises directly heating the attachment portion (11).

2. The method (100) according to the preceding claim, wherein directly heating the attachment portion (11) comprises using heating means (20) provided on the substrate (10).

3. The method (100) according to the preceding claim, wherein the heating means (20) comprises a heating element (21) that is integrated in the substrate (10).

4. The method (100) according to the preceding claim, wherein the heating element (21) is distributed in a pattern in a top portion of the substrate (10), wherein the heating element (21) preferably comprises copper and/or plated copper wire.

5. The method (100) according to any one of the preceding claims, wherein directly heating the attachment portion (11) comprises directly heating the adhesive (12).

6. The method (100) according to any one of the preceding claims, wherein at least partially heating the attachment portion (11) can be selectively activated by controlling auxiliary means (22), such as connection pins, wherein controlling auxiliary means (22) is preferably performed in a space apart from the attachment portion (11).

7. The method (100) according to claim 6, wherein controlling auxiliary means (22) comprises contacting connection pads (23) provided on the substrate (10) with the auxiliary means (22) to establish a connection of a heater circuit.

8. The method (100) according to claim 7, wherein the connection pads (23) are provided on the same side (10') of the substrate (10) where heating means (20) is arranged,
or wherein the connection pads (23) are provided on a side (10") opposite to the side where heating means (20) is arranged.

9. The method (100) according to any one of the preceding claims, wherein the attachment portion (11) comprises an attachment path that preferably resembles one or more contact surfaces of the component (3).

10. The method (100) according to any one of the preceding claims, wherein directly heating the attachment portion (11) comprises using radiation, convection, and/or conduction as heat transfer mechanisms.

11. The method (100) according to any one of the preceding claims, wherein the adhesive (12) comprises thermoset polymers, wherein the adhesive (12) preferably consists of thermoset polymers.

12. The method (100) according to any one of the preceding claims, further comprising further curing (120) the cured adhesive (12) using an oven for attaching the component (3) onto the substrate (10).

13. The method (100) according to any one of the preceding claims, wherein one or more contact surfaces of the component (3) form a frame, preferably having an essentially rectangular shape.

14. An active alignment process for one or more components (3), such as a camera or a sensor, the process comprising:
performing the method (100) according to any one of the preceding claims for attaching a component (3) onto a substrate (10), such as a printed circuit board, PCB,
wherein curing (120) the adhesive (12) is performed until a predefined temperature of the adhesive (12) is reached.

15. A system (1) for carrying out the method of claims 1-13 or the process of claim 14, the system (1) comprising:
a substrate (10), such as a printed circuit board, PCB, the substrate (10) comprising an attachment portion (11) for arranging (110) a component (3) on it;
heating means (20) provided on the substrate (10);
wherein the heating means (20) is configured to cure an adhesive (12) comprised by the attachment portion (11) by at least partially heating the attachment portion (11) and thereby at least partially attaching a component (3) to the substrate (10);
wherein at least partially heating the attachment portion (11) comprises directly heating the attachment portion (11).
